# EUROPEAN PATENT APPLICATION

(11) **EP 4 746 622 A1**
(43) Date of publication of application: **20.05.2026**
(21) Application number: 25214931.5
(22) Date of filing: 11.11.2025
(51) Int. Cl.: H10B 51/20, H10D 30/01, H10D 30/69, H10D 64/01, H10D 64/68, H10B 51/30, H10B 51/10

(54) **FERROELECTRIC FIELD EFFECT TRANSISTOR, MEMORY DEVICE INCLUDING THE SAME, AND ELECTRONIC APPARATUS INCLUDING THE MEMORY DEVICE**

(30) Priority: 18.11.2024 KR 20240164385
(71) Applicant: Samsung Electronics Co., Ltd., Suwon-si, Gyeonggi-do 16677 (KR)
(72) Inventor: NAM, Seunggeol, 16678 Suwon-si (KR); KIM, Sangwook, 16678 Suwon-si (KR); YANG, Jeeeun, 16678 Suwon-si (KR); CHOE, Dukhyun, 16678 Suwon-si (KR)
(74) Representative: Elkington and Fife LLP

(57) **Abstract**

A ferroelectric field effect transistor (FeFET), a memory device including the FeFET, and an electronic apparatus including the FeFET are provided. The FeFET includes a gate electrode (110), a ferroelectric layer (120) provided on the gate electrode, an intermediate conductive layer (130) provided on the ferroelectric layer, a gate insulating layer (140) provided on the intermediate conductive layer, a channel layer (150) provided on the gate insulating layer, and a source electrode (161) and a drain electrode (162) provided on the channel layer. The source electrode and the drain electrode each contact the gate insulating layer.

## Description

### FIELD OF THE INVENTION

The disclosure relates to a ferroelectric field effect transistor (FeFET), a memory device including the FeFET, and an electronic apparatus including the FeFET.

### BACKGROUND OF THE INVENTION

Ferroelectrics are materials that have ferroelectricity. That is ferroelectrics maintain spontaneous polarization by aligning the internal dipole moments even when no electric field is applied from the outside. Generally, ferroelectrics have a spontaneous dipole (electric dipole), that is, a spontaneous polarization, in a crystallized material structure because the charge distribution in a unit cell is non-centrosymmetric. Thus, the ferroelectric material has a remnant polarization due to dipoles even when no external electric field is applied to the ferroelectric material. Research has been recently conducted to apply ferroelectric field effect transistors (FeFETs) to memory devices. FeFETs are semiconductor devices with memory characteristics obtained by controlling a threshold voltage according to the polarization direction of a ferroelectric material by using a ferroelectric material as a gate insulating film. FeFETs have advantages of a low operating voltage, fast programming speed, etc.

### SUMMARY OF THE INVENTION

Provided are a ferroelectric field effect transistor (FeFET), a memory device including the FeFET, and an electronic apparatus including the FeFET.

Additional aspects will be set forth in part in the description which follows and, in part, will be apparent from the description, or may be learned by practice of the presented embodiments of the disclosure.

According to an aspect of the disclosure, a FeFET includes a gate electrode, a ferroelectric layer on the gate electrode, an intermediate conductive layer on the ferroelectric layer such that the ferroelectric layer is between the intermediate conductive layer and the gate electrode; a gate insulating layer on the intermediate conductive layer such that the intermediate conductive layer is between the gate insulating layer and the ferroelectric layer; a channel layer on the gate insulating layer such that the gate insulating layer is between the channel layer and the intermediate conductive layer both the source electrode and the drain electrode directly contacting the gate insulating layer.

The channel layer may define a first through hole and a second through hole the channel layer, the source electrode may be in contact with the gate insulating layer through the first through hole, and the drain electrode may be in contact with the gate insulating layer through the second through hole.

The channel layer may include at least one of a group IV semiconductor, a group III-V semiconductor compound, an oxide semiconductor, a nitride semiconductor, a nitride oxide semiconductor, a two-dimensional (2D) semiconductor, a quantum dot, or an organic semiconductor.

The channel layer may include a doping region in contact with at least one of the source electrode and the drain electrode.

An interface layer may be between the channel layer and at least one of the source electrode or the drain electrode.

Each of the gate electrode and the intermediate conductive layer may independently include at least one of a metal, a metal nitride, a metal oxide, or a highly doped poly silicon.

The ferroelectric layer may include a fluorite-based ferroelectric material, a nitride-based ferroelectric material, or a perovskite-based ferroelectric material.

The gate insulating layer may include at least one of silicon oxide, silicon nitride, hafnium oxide, or zirconium oxide.

According to another aspect of the disclosure, a memory device includes a plurality of memory cells perpendicular to a substrate, each of the plurality of memory cells including a gate electrode, a ferroelectric layer on the gate electrode, an intermediate conductive layer on the ferroelectric layer such that the ferroelectric layer is between the intermediate conductive layer and the gate electrode, a gate insulating layer on the intermediate conductive layer such that the intermediate conductive layer is between the gate insulating layer and the ferroelectric layer, a channel layer on the gate insulating layer such that the gate insulating layer is between the channel layer and the intermediate conductive layer; and a source electrode and a drain electrode on the channel layer, both the source electrode and the drain electrode directly contacting the gate insulating layer.

Each of the source electrode and the drain electrode may be configured to extend in a direction perpendicular to the substrate and be shared by the plurality of memory cells.

The source electrode and the drain electrode may be spaced apart from each other in a first direction parallel to the substrate.

The gate electrode, the ferroelectric layer, the intermediate conductive layer, the gate insulating layer, and the channel layer may be stacked in a second direction parallel to the substrate.

The gate electrode, the ferroelectric layer, the intermediate conductive layer, the gate insulating layer, and the channel layer may be disposed on both sides of each of the source electrode and the drain electrode.

The gate electrode, the ferroelectric layer, the intermediate conductive layer, the gate insulating layer, and the channel layer may be disposed on one side of each of the source electrode and the drain electrode.

The gate electrode may be configured to extend in a direction perpendicular to the substrate and be shared by the plurality of memory cells.

The source electrode and the drain electrode may be spaced apart from each other in a direction parallel to the substrate.

The ferroelectric layer, the intermediate conductive layer, and the gate insulating layer may surround the gate electrode.

The channel region may include a doping region may in contact with at least one of the source electrode or the drain electrode.

An interface layer may be between the channel layer and at least one of the source electrode or the drain electrode.

According to another aspect of the disclosure, an electronic apparatus including processing circuitry and the memory device described above is provided.

According to another aspect of the disclosure, a method of manufacturing a memory device includes alternately stacking a plurality of interlayer insulating layers and a plurality of sacrificial layers on a substrate, forming a through hole penetrating the plurality of interlayer insulating layers and the plurality of sacrificial layers in perpendicular to the substrate, forming a plurality of recesses by etching the plurality of sacrificial layers exposed through the through hole, forming an intermediate conductive layer to fill inside of each of the plurality of recesses, sequentially forming a gate insulating layer and a channel layer on an inner wall of the through hole, and forming a filling insulating layer inside the channel layer to fill the through hole, after removing each of the plurality of sacrificial layers, sequentially forming a ferroelectric layer and a gate electrode in the intermediate conductive layer, forming a source through hole and a drain through hole by etching the filling insulating layer and the channel layer in perpendicular to the substrate, and forming a source electrode and a drain electrode to fill the source through hole and the drain through hole.

Each of the source electrode and the drain electrode may be formed to contact the gate insulating layer.

Each of the source electrode and the drain electrode may be formed to extend in a direction perpendicular to the substrate.

The source electrode and the drain electrode may be formed to be spaced apart from each other in a first direction parallel to the substrate.

The gate electrode, the ferroelectric layer, the intermediate conductive layer, the gate insulating layer, and the channel layer may be stacked in a second direction parallel to the substrate.

The channel layer may include at least one of a group IV semiconductor, a group III-V semiconductor compound, an oxide semiconductor, a nitride semiconductor, a nitride oxide semiconductor, a 2D semiconductor, a quantum dot, or an organic semiconductor.

Each of the gate electrode and the intermediate conductive layer may independently include at least one of a metal, a metal nitride, a metal oxide, or highly doped poly silicon.

The ferroelectric layer may include at least one of a fluorite-based ferroelectric material, a nitride-based ferroelectric material, or a perovskite-based ferroelectric material.

According to another aspect of the disclosure, a method of manufacturing a memory device includes alternately stacking a plurality of interlayer insulating layers and a plurality of sacrificial layers on a substrate, forming a through hole penetrating the plurality of interlayer insulating layers and the plurality of sacrificial layers in perpendicular to the substrate, forming a plurality of recesses by etching the plurality of sacrificial layers exposed through the through hole, sequentially forming a channel layer, a gate insulating layer, and an intermediate conductive layer to fill inside of each of the plurality of recesses, forming a ferroelectric layer on an inner wall of the through hole, and forming a gate electrode inside the ferroelectric layer to fill the through hole, after removing each of the plurality of sacrificial layers, exposing a part of the gate insulating layer by etching a part of the channel layer, and forming a source electrode and a drain electrode on the channel layer to be in contact with the exposed part of the gate insulating layer.

The gate electrode may be formed to extend in a direction perpendicular to the substrate.

The source electrode and the drain electrode may be formed to be spaced apart from each other in a direction parallel to the substrate.

The ferroelectric layer, the intermediate conductive layer, and the gate insulating layer may be formed to surround the gate electrode.

The channel layer may include at least one of a group IV semiconductor, a group III-V semiconductor compound, an oxide semiconductor, a nitride semiconductor, a nitride oxide semiconductor, a 2D semiconductor, a quantum dot, or an organic semiconductor.

Each of the gate electrode and the intermediate conductive layer may independently include at least one of a metal, a metal nitride, a metal oxide, or highly doped poly silicon.

The ferroelectric layer may include a fluorite-based ferroelectric material, a nitride-based ferroelectric material, or a perovskite-based ferroelectric material.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic cross-sectional view of a ferroelectric field effect transistor (FeFET) according to at least one example embodiment;
FIG. 2 is a cross-sectional view of a FeFET according to a comparative example;
FIG. 3 is a cross-sectional view of a FeFET according to at least one example embodiment;
FIG. 4 is a cross-sectional view of a FeFET according to at least one example embodiment;
FIG. 5A is a plan view illustrating a memory device according to at least one example embodiment;
FIG. 5B illustrates a planar structure of each memory cell of the memory device shown in FIG. 5A;
FIG. 5C is a cross-sectional view taken along line I-I' of FIG. 5A;
FIG. 6 is a plan view of a memory device according to at least one example embodiment;
FIG. 7A is a plan view of a memory device according to at least one example embodiment;
FIG. 7B is a cross-sectional view taken along line II-II' of FIG. 7A;
FIGS. 8A to 16B are diagrams for explaining a method of manufacturing a memory device according to at least one example embodiment;
FIGS. 17A to 26B are diagrams for explaining a method of manufacturing a memory device according to at least one example embodiment;
FIG. 27 is a conceptual view schematically illustrating a device architecture applicable to an electronic apparatus;
FIG. 28 is a block diagram of a memory system according to at least one example embodiment; and
FIG. 29 is a block diagram of a neuromorphic apparatus according to at least one example embodiment and an external device connected thereto.

### DETAILED DESCRIPTION

Reference will now be made in detail to embodiments, examples of which are shown in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments are described below in detail with reference to the accompanying drawings. In the drawings below, the same reference numerals refer to the same constituent elements, and sizes of each constituent element in the drawings may be exaggerated for convenience of explanation and clarity. Embodiments described below are examples, and other modifications may be produced from the embodiments. Additionally, when the terms "about" or "substantially" are used in this specification in connection with a numerical value and/or geometric terms, it is intended that the associated numerical value includes a manufacturing tolerance (e.g., ±10%) around the stated numerical value. Further, regardless of whether numerical values and/or geometric terms are modified as "about" or "substantially," it will be understood that these values should be construed as including a manufacturing or operational tolerance (e.g., ±10%) around the stated numerical values and/or geometry.

When a constituent element is disposed "above" or "on" to another constituent element, the constituent element may be only directly on the other constituent element or above the other constituent elements in a non-contact manner. Additionally, spatially relative terms, such as above, below, etc. are represented herein based on the direction illustrated in the drawings and may be represented otherwise when the orientation of the corresponding object changes. In other words, such spatially relative terms are intended to encompass different orientations of the device in use or operation in addition to the orientation depicted in the figures, such that the device may be otherwise oriented (rotated 90 degrees or at other orientations) and the spatially relative terms used herein interpreted accordingly.

As used herein, the singular forms "a," "an" and "the" are intended to include the plural forms as well, unless the context clearly indicates otherwise. It will be further understood that the terms "comprises" and/or "comprising" used herein specify the presence of stated features or elements, but do not preclude the presence or addition of one or more other features or elements.

The use of the terms "a," "an," "the," and similar referents in the context of describing the disclosure is to be construed to cover both the singular and the plural. Also, the operations of all methods described herein can be performed in any suitable order unless otherwise indicated herein or otherwise clearly contradicted by context. The disclosure is not limited to the described order of the steps.

In addition, terms such as "... portion," "... unit," "... module," and "... block" stated in the disclosure may signify a unit configured to process at least one function or operation and the unit may be embodied by and/or include processing circuitry, such as hardware, software, or a combination of hardware and software. For example, the processing circuitry may include, but is not limited to, a central processing unit (CPU), an application processor (AP), an arithmetic logic unit (ALU), a graphic processing unit (GPU), a digital signal processor, a microcomputer, a field programmable gate array (FPGA), a System-on-Chip (SoC) a programmable logic unit, a microprocessor, or an application-specific integrated circuit (ASIC), etc., unless expressly indicated otherwise.

In addition, the connecting lines, or connectors shown in the various figures presented are intended to represent functional relationships and/or physical or logical couplings between the various elements. It should be noted that many alternative or additional functional relationships, physical connections or logical connections may be present in a practical device.

The use of any and all examples, or language (e.g., "such as") provided herein, is intended merely to better illuminate the disclosure and does not pose a limitation on the scope of the disclosure unless otherwise claimed.

A ferroelectric field effect transistor (FeFET) is a semiconductor device with non-volatile memory characteristics by using a phenomenon in which the threshold voltage of a transistor changes by switching of spontaneous polarization. The FeFET may have a minimum threshold voltage and a maximum threshold voltage determined by a polarization state of the ferroelectric, and a difference between the minimum threshold voltage and the maximum threshold voltage may be a memory window (MW) corresponding to a sensing margin.

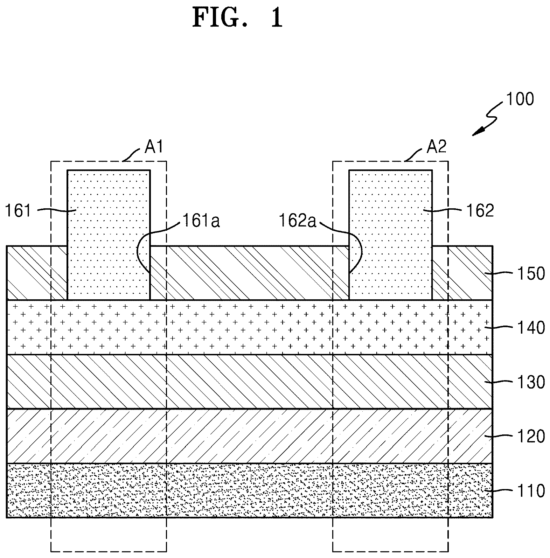

FIG. 1 is a schematic cross-sectional view of a FeFET 100 according to at least one example embodiment. The FeFET 100 shown in FIG. 1 may be referred to as having a metal-ferroelectric-metal-insulator-semiconductor (MFMIS) structure. For example, each memory cell of a memory device including a plurality of memory cells may include the FeFET 100 shown in FIG. 1. Further, as noted above, herein the FeFET 100 may also be referred to as a semiconductor device.

Referring to FIG. 1, the FeFET 100 may include a gate electrode 110, a ferroelectric layer 120, an intermediate conductive layer 130, a gate insulating layer 140, a channel layer 150, a source electrode 161, and a drain electrode 162, which are sequentially stacked.

The gate electrode 110 includes a conductive material (e.g., a zero-band gap material and/or the like). For example, the gate electrode 110 may include a metal, a metal nitride, a metal oxide, polysilicon, etc. For example, the gate electrode 110 may include at least one of W, TiN, TaN, WN, NbN, Mo, Ru, Ir, RuO, IrO, and/or highly doped poly silicon. However, the disclosure is not limited thereto. The gate electrode 110 may have a stack structure of a plurality of materials. For example, the gate electrode 110 may have a stack structure of a metal nitride layer/metal layer such as TiN/W. However, this is merely an example, and the disclosure is not limited thereto.

The ferroelectric layer 120 is provided on the gate electrode 110. The ferroelectric layer 120 includes a ferroelectric. As noted above, a ferroelectric is a material having ferroelectricity, that is, internal electric dipole moments of the ferroelectric are aligned to maintain spontaneous polarization. Ferroelectrics have remnant polarization due to a dipole even in a state where an electric field is not applied from the outside. In ferroelectrics, a direction of polarization may be switched in units of domain by applying an external electric field.

The ferroelectric layer 120 may include, for example, a fluorite-based material, a nitride-based material, and/or a perovskite-based material. The fluorite-based material may include a non-centrosymmetric phase of at least one of, for example, hafnium oxide (HfO), zirconium oxide (ZrO), and/or hafnium-zirconium oxide (HfZrO). The nitride-based material may include, for example, AlScN, etc. The perovskite-based material may include lead zirconate titanate (PZT), strontium bismuth tantalate (SBT), barium titanate (BTO), etc. The ferroelectric layer 120 may further include a certain dopant. The dopant may include at least one of, for example, La, Y, Gd, Si, Al, Mg, Sr, and/or Ba. However, these are merely examples, and the disclosure is not limited thereto.

The intermediate conductive layer 130 is provided on the ferroelectric layer 120. The intermediate conductive layer 130 may serve as a floating electrode. The intermediate conductive layer 130 includes a conductive material like the gate electrode 110. For example, the intermediate conductive layer 130 may include a metal, a metal nitride, a metal oxide, polysilicon, etc. For example, the intermediate conductive layer 130 may include at least one of W, TiN, TaN, WN, NbN, Mo, Ru, Ir, RuO, IrO, and/or highly doped poly silicon. However, the disclosure is not limited thereto. The intermediate conductive layer 130 may include the same material as the gate electrode 110, but is not limited thereto, and the intermediate conductive layer 130 may include a material different from that of the gate electrode 110.

The gate insulating layer 140 is provided in the intermediate conductive layer 130. The gate insulating layer 140 includes an insulator, for example, at least one of silicon oxide (SiO), silicon nitride (SiN), hafnium oxide (HfO), and/or zirconium oxide (ZrO). However, this is merely an example, and the disclosure is not limited thereto.

The channel layer 150 is provided on the gate insulating layer 140. The channel layer 150 includes a semiconductor, for example, a group IV semiconductor such as Si, Ge, SiGe, etc., and/or a group III-V semiconductor compound. In at least one example embodiment, the channel layer 150 may include, for example, an oxide semiconductor (such as an indium gallium zinc oxide (IGZO)), a nitride semiconductor, and/r a nitride oxide semiconductor. In at least one example embodiment, the channel layer 150 may include, for example, a two-dimensional (2D) semiconductor material, a quantum dot, and/or an organic semiconductor. The 2D semiconductor material is a semiconductor material having a layer structure in which constituent atoms are 2D bonded. The 2D semiconductor material may include, for example, transition metal dichalcogenide (TMD) which is a compound of a transition metal and a chalcogen element. The channel layer 150 may further include a dopant. Here, the dopant may include a p-type dopant or an n-type dopant. The p-type dopant may include, for example, B, Al, Ga, In, etc., and the n-type dopant may include, for example, P, As, Sb, etc. Meanwhile, the materials mentioned above are merely examples, and the disclosure is not limited thereto.

A source electrode 161 and a drain electrode 162 are provided on the channel layer 150. The source electrode 161 and the drain electrode 162 may be provided on both sides of the channel layer 150, and a channel may be formed between the source electrode 161 and the drain electrode 162. The channel may be configured to electrically connect the source electrode 161 and the drain electrode 162 while switched on. The source electrode 161 and the drain electrode 162 are provided to be in contact with the gate insulating layer 140 through the channel layer 150.

For example, a first through hole 161a and a second through hole 162a exposing an upper surface of the gate insulating layer 140 are respectively formed on both sides of the channel layer 150; and the source electrode 161 is provided to contact the upper surface of the gate insulating layer 140 through the first through hole 161a, and the drain electrode 162 is provided to contact the upper surface of the gate insulating layer 140 through the second through hole 162a. In addition, the source electrode 161 and the drain electrode 162 are provided to be in contact with the channel layer 150. Like the gate electrode 110 and the intermediate conductive layer 130, the source electrode 161 and the drain electrode 162 may each include a conductive material.

In the FeFET 100 according to at least one example embodiment, the source electrode 161 and the drain electrode 162 are provided to be in direct contact with the gate insulating layer 140, and thus, a metal-ferroelectric-metal-insulator-metal (MFMIM) structure may be formed in an A1 region where the source electrode 161 is located and an A2 region where the drain electrode 162 is located. The source electrode 161 and the drain electrode 162 are in direct contact with the gate insulating layer 140, and thus there is no channel depletion region between the source/drain electrodes 161 and 162 and the gate insulating layer 140, thereby reducing the write voltage and/or increasing the write speed.

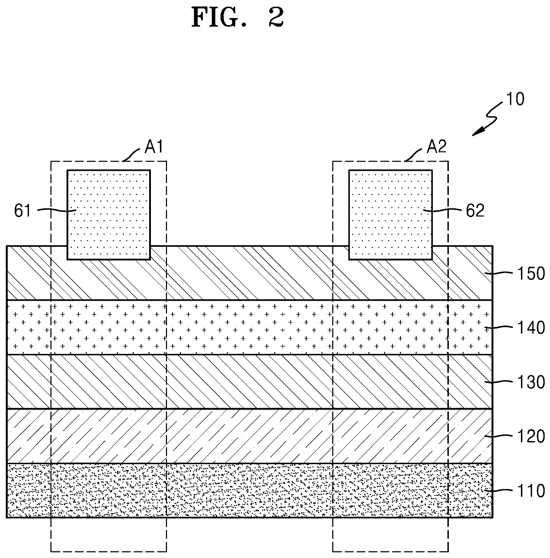

FIG. 2 is a cross-sectional view of a FeFET 10 according to a comparative example. Hereinafter, differences from the above-described embodiment will be mainly described.

Referring to FIG. 2, a source electrode 61 and a drain electrode 62 are provided in both sides of the channel layer 150, respectively. Here, the source electrode 61 and the drain electrode 62 are provided on an upper portion of the channel layer 150, are in contact with the channel layer 150, and/or spaced apart from the gate insulating layer 140. That is, unlike the at least one example embodiment described above with reference to FIG. 1, the source electrode 61 and the drain electrode 62 are provided not to be in contact with the gate insulating layer 140.

In the FeFET 10 according to the comparative example, the source electrode 61 and the drain electrode 62 are provided to be in contact with the channel layer 150 without being in contact with the gate insulating layer 140, and thus a metal-ferroelectric-metal-insulator-semiconductor-metal (MFMISM) structure may be formed in the A1 region where the source electrode 61 is located and the A2 region where the drain electrode 62 is located. In such a structure, when charges to screen ferroelectric polarization are insufficient in a channel material, a depletion region is formed in the channel layer 150 between the source/drain electrodes 61 and 62 and the gate insulating layer 140, thereby lowering the capacitance, and accordingly the voltage required to change the ferroelectric polarization may increase.

However, in the FeFET 100 according to the at least one example embodiment described above, the source electrode 161 and the drain electrode 162 are in direct contact with the gate insulating layer 140, and thus there is no channel depletion region between the source/drain electrodes 161 and 162 and the gate insulating layer 140, thereby reducing the write voltage and/or increasing the write speed.

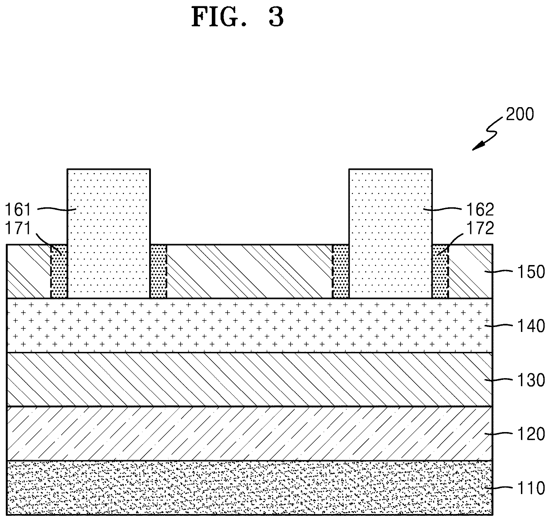

FIG. 3 is a cross-sectional view of a FeFET 200 according to at least one example embodiment. Hereinafter, differences from the FeFET 100 shown in FIG. 1 will be mainly described.

Referring to FIG. 3, the source electrode 161 and the drain electrode 162 are provided in both sides of the channel layer 150, respectively. The source electrode 161 and the drain electrode 162 are provided to be in contact with an upper surface of the gate insulating layer 140 through the channel layer 150. In addition, the source electrode 161 and the drain electrode 162 are provided to be in contact with the channel layer 150. When the channel layer 150 includes, for example, a group IV semiconductor such as Si, a first doped region 171 may be formed in the channel layer 150 in contact with the source electrode 161, and a second doped region 172 may be formed in the channel layer 150 in contact with the drain electrode 162. The first doped region 171 may reduce contact resistance between the source electrode 161 and the channel layer 150, and the second doped region 172 may reduce contact resistance between the drain electrode 162 and the channel layer 150.

The first doped region 171 and the second doped region 172 may be doped with a p-type dopant or an n-type dopant. For example, when the channel layer 150 include a p-type semiconductor, the first doped region 171 and the second doped region 172 may be doped with the n-type dopant, and when the channel layer 150 includes an n-type semiconductor, the first doped region 171 and the second doped region 172 may be doped with the p-type dopant.

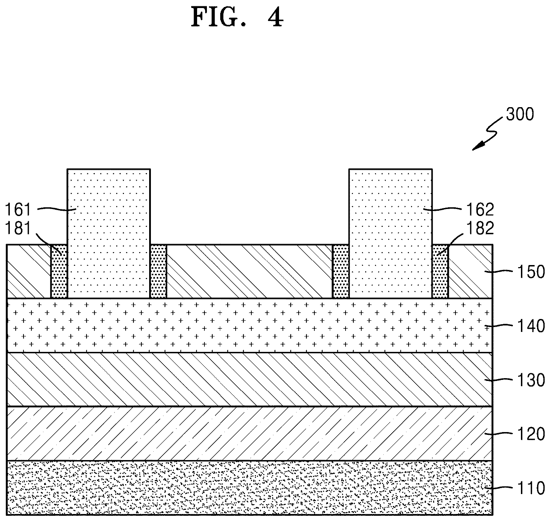

FIG. 4 is a cross-sectional view of a FeFET 300 according to at least one example embodiment. Hereinafter, differences from the FeFET 100 shown in FIG. 1 will be mainly described.

Referring to FIG. 4, the source electrode 161 and the drain electrode 162 are provided in both sides of the channel layer 150, respectively. The source electrode 161 and the drain electrode 162 are provided to be in contact with an upper surface of the gate insulating layer 140 through the channel layer 150. In addition, the source electrode 161 and the drain electrode 162 are provided to be in contact with the channel layer 150. When the channel layer 150 includes, for example, an oxide semiconductor such as IGZO, a first interface layer 181 may be formed between the source electrode 161 and the channel layer 150, and a second interface layer 182 may be formed between the drain electrode 162 and the channel layer 150. The first interface layer 181 may reduce contact resistance between the source electrode 161 and the channel layer 150, and the second interface layer 182 may reduce contact resistance between the drain electrode 162 and the channel layer 150. The first interface layer 181 and the second interface layer 182 may each include, for example, a conductive oxide such as ITO, but the examples are not limited thereto.

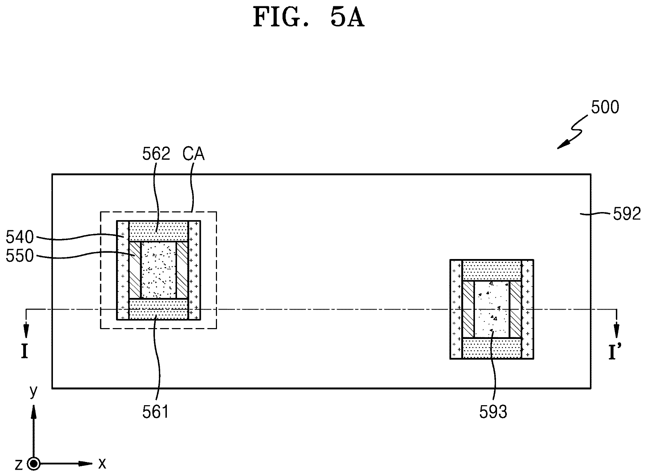

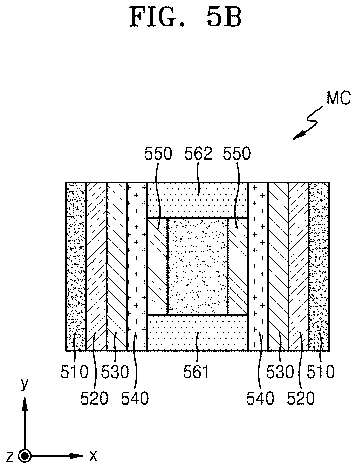

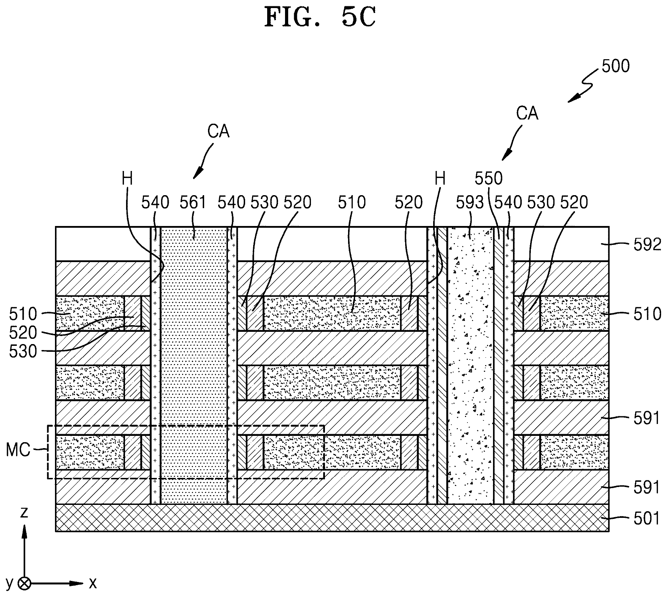

FIG. 5A is a plan view illustrating a memory device 500 according to at least one example embodiment. FIG. 5B illustrates a planar structure of each memory cell MC of the memory device 500 according to at least one example embodiment. FIG. 5C is a cross-sectional view taken along line I-I' of FIG. 5A. The memory device 500 shown in FIGS. 5A to 5C may be a three-dimensional (3D) ferroelectric memory device (e.g., a vertical NAND flash memory device).

Referring to FIGS. 5A to 5C, the memory device 500 includes a plurality of cell arrays CA which are disposed on a substrate 501. Two cell arrays CA are shown in FIG. 5A and 5C, but the disclosure is not limited thereto, and the memory device 100 may include various numbers of cell arrays CA. Each cell array CA includes a plurality of memory cells MC stacked in a direction (z-axis direction) perpendicular to the substrate 501, and each memory cell MC may include a FeFET having the above-described MFMIS structure. Additionally, the two cell arrays CA are shown as being staggered; but the disclosure is not limited thereto.

The substrate 501 may include various materials. For example, the substrate 501 may include a single crystal silicon substrate, a compound semiconductor substrate, and/or a silicon-on-insulator (SOI) substrate. However, these are only some examples, and the substrate 501 of various materials may be used. In addition, the substrate 501 may further include, for example, an impurity region caused by doping, an electronic device such as a transistor, and/or a peripheral circuit selecting and controlling memory cells that store data.

The plurality of memory cells MC are stacked in the direction (z-axis direction) perpendicular to the substrate 501, and each memory cell MC includes a gate electrode 510, a ferroelectric layer 520, an intermediate conductive layer 530, a gate insulating layer 540, a channel layer 550, a source electrode 561, and a drain electrode 562. Here, the gate insulating layer 540, the channel layer 550, the source electrode 561, and the drain electrode 562 may be provided to extend in a direction perpendicular to the substrate 501, and thus may be shared by the plurality of memory cells MCs.

The gate electrode 510 includes a conductive material. For example, the gate electrode 510 may include a metal, a metal nitride, a metal oxide, polysilicon, etc. For example, the gate electrode 510 may include at least one of W, TiN, TaN, WN, NbN, Mo, Ru, Ir, RuO, IrO, and highly doped poly silicon. However, the disclosure is not limited thereto.

The ferroelectric layer 520 includes a ferroelectric, for example, a fluorite-based ferroelectric material, a nitride-based ferroelectric material, and/or a perovskite-based ferroelectric material. The fluorite-based material may include at least one of, for example, hafnium oxide (HfO), zirconium oxide (ZrO), and hafnium-zirconium oxide (HfZrO). The nitride-based material may include, for example, AlScN, etc. The perovskite-based material may include, for example, PZT, SBT, BTO, etc. The ferroelectric layer 520 may further include a certain dopant. The dopant may include at least one of, for example, La, Y, Gd, Si, Al, Mg, Sr, and/or Ba. However, the disclosure is not limited thereto. The intermediate conductive layer 530 may include a conductive material. For example, the intermediate conductive layer 530 may include a metal, a metal nitride, a metal oxide, polysilicon, etc.

The gate insulating layer 540 includes an insulator, for example at least one of silicon oxide (SiO), silicon nitride (SiN), hafnium oxide (HfO), and/or zirconium oxide (ZrO). However, these are merely examples, and the disclosure is not limited thereto.

The channel layer 550 may include a semiconductor, for example, a group IV semiconductor such as Si, Ge, and SiGe, a group III-V semiconductor compound, an oxide semiconductor, a nitride semiconductor, a nitride semiconductor, a 2D semiconductor material, a quantum dot, and/or an organic semiconductor. The channel layer 150 may further include a dopant. The source electrode 561 and the drain electrode 562 may each include a conductive material.

A plurality of first insulating layers 591 are stacked to be spaced apart from each other in the direction (z-axis direction) perpendicular to the substrate 501, and a second insulating layer 592 may be provided in the uppermost first insulating layer 591. In addition, a plurality of through holes H penetrating the first insulating layers 591 and the second insulating layer 592 are formed to extend in the direction (z-axis direction) perpendicular to the substrate 501.

The gate electrode 510, the ferroelectric layer 520, and the intermediate conductive layer 530 are stacked in a direction parallel to the substrate 501 in each of the plurality of first insulating layers 591. In addition, the gate insulating layer 540 extends in the direction (z-axis direction) perpendicular to the substrate 501 and contacts the intermediate conductive layers 530, and a channel layer 550 extends in a direction (z-axis direction) perpendicular to the substrate 501 and is provided in the gate insulating layer 540. The gate insulating layer 540 and the channel layer 550 may be shared by the plurality of memory cells MC.

The source electrode 561 and the drain electrode 562 are provided on an inner wall of each through hole H to be spaced apart from each other in a direction parallel to the substrate 501. Here, the source electrode 561 and the drain electrode 562 are provided to be in contact with the gate insulating layer 540 and the channel layer 550. The source electrode 561 and the drain electrode 562 are provided to extend in the direction (z-axis direction) perpendicular to the substrate 501, and may be shared by the plurality of memory cells MC. The through hole H between the source electrode 561 and the drain electrode 562 may be filled with a third insulating layer 593. The third insulating layer 593 may also be referred to as an internal support.

The source electrode 561 and the drain electrode 562 are provided on the channel layer 550 to be spaced apart from each other in a first direction (y-axis direction) parallel to the substrate 501. In addition, the gate electrode 510, the ferroelectric layer 520, the intermediate conductive layer 530, the gate insulating layer 540, and the channel layer 550 may be sequentially stacked in a second direction (x-axis direction) parallel to the substrate 501. The gate electrode 510, the ferroelectric layer 520, the intermediate conductive layer 530, the gate insulating layer 540, and the channel layer 550 may be provided in both sides of the source/drain electrodes 561 and 562, respectively. Here, as shown in FIG. 5B, the gate electrode 510, the ferroelectric layer 520, the intermediate conductive layer 530, the gate insulating layer 540, and the channel layer 550 may be disposed symmetrically with respect to the source electrode 561 and the drain electrode 562. Meanwhile, although not shown in the drawings, a doping region may be further formed in the channel layer 550 which is in contact with the source electrode 561 and the drain electrode 562, or an interface layer may be further formed between the source electrode 561 and the drain electrode 562 and the channel layer 550.

In the memory device 500 according to the embodiment, the source electrode 561 and the drain electrode 562 are provided to be in direct contact with the gate insulating layer 540, and thus there is no channel depletion region between the source electrode 561 and the drain electrode 562 and the gate insulating layer 440, thereby reducing the write voltage and/or increasing the write speed.

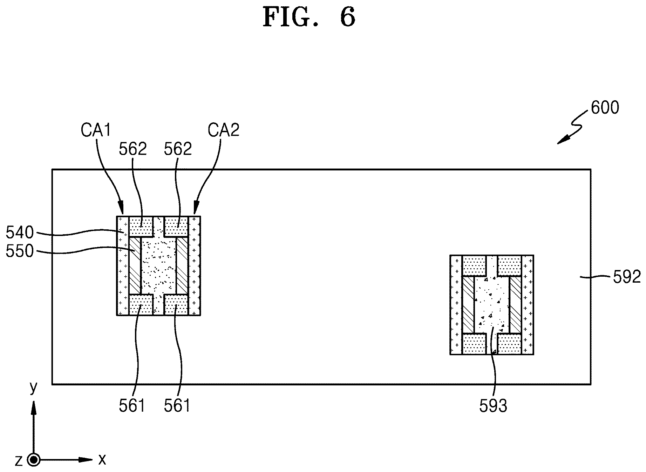

FIG. 6 is a plan view of a memory device 600 according to at least one example embodiment. Hereinafter, differences from the memory device 500 shown in FIGS. 5A to 5C described above will be mainly described.

In each memory cell MC of the memory device 500 described above, the gate electrode 510, the ferroelectric layer 520, the intermediate conductive layer 530, the gate insulating layer 540, and the channel layer 550 are respectively provided on both sides of the source electrode 561 and the drain electrode 562. In each memory cell MC of the memory device 600 according to the embodiment, the gate electrode 510 of FIG. 5B, the ferroelectric layer 520, the intermediate conductive layer 530, the gate insulating layer 540, and the channel layer 550 are provided in one side of the source electrode 561 and the drain electrode 562. Specifically, in the memory cell MC of a first cell array CA1, the gate electrode 510, the ferroelectric layer 520, the intermediate conductive layer 530, the gate insulating layer 540, and the channel layer 550 are provided on the left side of the source electrode 561 and the drain electrode 562. In the memory cell MC of a second cell array CA2, the gate electrode 510, the ferroelectric layer 520, the intermediate conductive layer 530, the gate insulating layer 540, and the channel layer 550 are provided on the right side of the source electrode 561 and the drain electrode 562.

The first cell array CA1 and the second cell array CA2 of the memory device 600 according to the at least one example embodiment may be manufactured by dividing the source electrode 561 and the drain electrode 562 of the cell array CA of the memory device 500 according to the above-described embodiment into two, respectively, in the direction (z-axis direction) perpendicular to the substrate 501. Therefore, the memory device 600 according to the embodiment may increase the number of memory cells MC by twice compared to the memory device 500 described above in the same area.

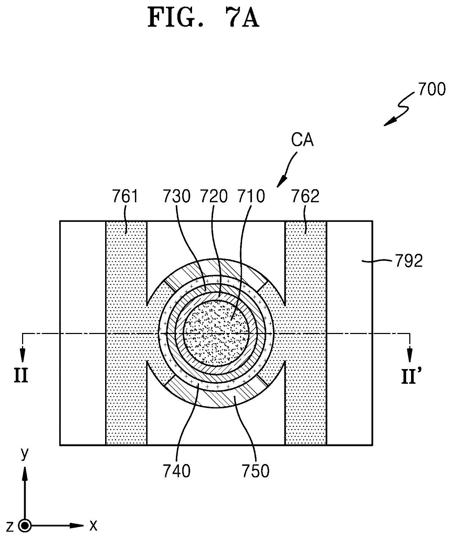

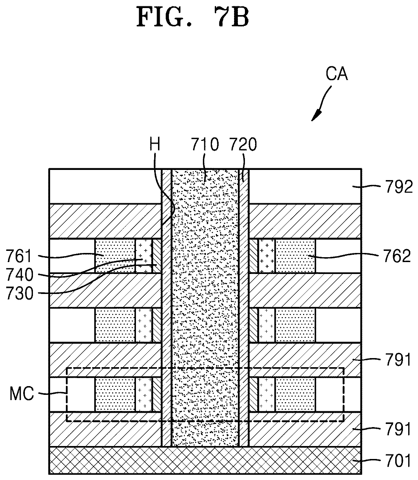

FIG. 7A is a plan view of a memory device 700 according to at least one example embodiment. FIG. 7A is the plan view of each cell array CA of the memory device 700 according to at least one example embodiment. FIG. 7B is a cross-sectional view taken along line II-II' of FIG. 7A.

Referring to FIGS. 7A and 7B, the memory device 700 includes the plurality of cell arrays CA which are 2D disposed on a substrate 701. Although one cell array CA is shown in FIG. 7B for convenience, the memory device 700 may include various numbers of cell arrays CA. Each cell array CA includes the plurality of memory cells MC stacked in a direction (z-axis direction) perpendicular to the substrate 701, and each memory cell MC may include a FeFET having the above-described MFMIS structure.

The substrate 701 may include various materials. For example, the substrate 701 may include a single crystal silicon substrate, a compound semiconductor substrate, and/or an SOI substrate. In addition, the substrate 701 may further include, for example, an impurity region caused by doping, an electronic device such as a transistor, and/or a peripheral circuit selecting and controlling memory cells that store data.

The plurality of memory cells MC are stacked in the direction (z-axis direction) perpendicular to the substrate 701, and each memory cell MC includes a gate electrode 710, a ferroelectric layer 720, an intermediate conductive layer 730, a gate insulating layer 740, a channel layer 750, a source electrode 761, and a drain electrode 762. Here, the gate electrode 710 and the ferroelectric layer 720 may be provided to extend in the direction (z-axis direction) perpendicular to the substrate 701 and may be shared by the plurality of memory cells MC.

The gate electrode 710 includes a conductive material. For example, the gate electrode 710 may include a metal, a metal nitride, a metal oxide, polysilicon, etc. The ferroelectric layer 720 includes a ferroelectric, for example, a fluorite-based ferroelectric material, a nitride-based ferroelectric material, and/or a perovskite-based ferroelectric material. The ferroelectric layer 720 may further include a certain dopant. The intermediate conductive layer 730 may include a conductive material. The gate insulating layer 740 includes an insulator, for example, at least one of silicon oxide (SiO), silicon nitride (SiN), hafnium oxide (HfO), and/or zirconium oxide (ZrO). The channel layer 750 includes a semiconductor, for example, a group IV semiconductor, a group III-V semiconductor compound, an oxide semiconductor, a nitride semiconductor, a nitride semiconductor, a 2D semiconductor material, a quantum dot, and/or an organic semiconductor. The channel layer 750 may further include a dopant. The source electrode 761 and the drain electrode 762 may each include a conductive material.

A plurality of first insulating layers 791 are stacked to be spaced apart from each other in the direction (z-axis direction) perpendicular to the substrate 701, and a second insulating layer 792 may be provided in the uppermost first insulating layer 791. The through hole H penetrating the first insulating layers 791 and the second insulating layer 792 is formed to extend in the direction (z-axis direction) perpendicular to the substrate 701. Here, the through hole H may be formed to have, for example, a circular cross-section.

The ferroelectric layer 720 is provided on an inner wall of the through hole H, and the gate electrode 710 is provided in the through hole H inside the ferroelectric layer 720. The gate electrode 710 is provided to extend in the direction (z-axis direction) perpendicular to the substrate 701, and the ferroelectric layer 720 is provided to surround the gate electrode 710. The ferroelectric layer 720 may be provided to be in contact with the intermediate conductive layers 730 disposed in perpendicular to the substrate 701 to be described below.

The intermediate conductive layer 730 and the gate insulating layer 740 are respectively provided between the plurality of first insulating layers 791 to surround the ferroelectric layer 720, and the channel layer 750 is provided in the gate insulating layer 740. Here, the channel layer 750 is provided to expose both sides of the gate insulating layer 740. The source electrode 761 and the drain electrode 762 are provided on the channel layer 750 to be spaced apart from each other in the first direction (x-axis direction) parallel to the substrate 701. Specifically, the source electrode 761 is provided on the channel layer 750 to contact an exposed one part of the gate insulating layer 740, and the drain electrode 762 is provided on the channel layer 750 to contact the exposed other part of the gate insulating layer 740. Each of the source electrode 761 and the drain electrode 762 is provided to extend in the second direction (y-axis direction) parallel to the substrate 701, and may be shared by the memory cell MC disposed in the direction (y-axis direction) parallel to the substrate 701. Meanwhile, although not shown in the drawings, a doping region may be further formed in the channel layer 750 in contact with the source electrode 761 and the drain electrode 762, or an interface layer may be further formed between the source electrode 761 and the drain electrode 762 and the channel layer 750.

In the memory device 700 according to the at least one example embodiment, the source electrode 761 and the drain electrode 762 are provided to be in direct contact with the gate insulating layer 740, and thus there is no channel depletion region between the source electrode 761 and the drain electrode 762 and the gate insulating layer 740, thereby reducing the write voltage and/or increasing the write speed.

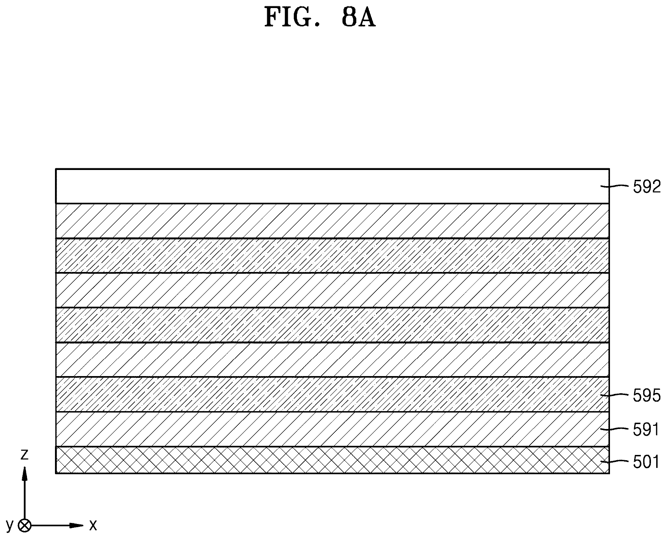

FIGS. 8A to 16B are diagrams for explaining a method of manufacturing the memory device 500 according to at least one example embodiment. The method of manufacturing the memory device 500 shown in FIGS. 5A to 5C is shown in FIGS. 8A to 16B.

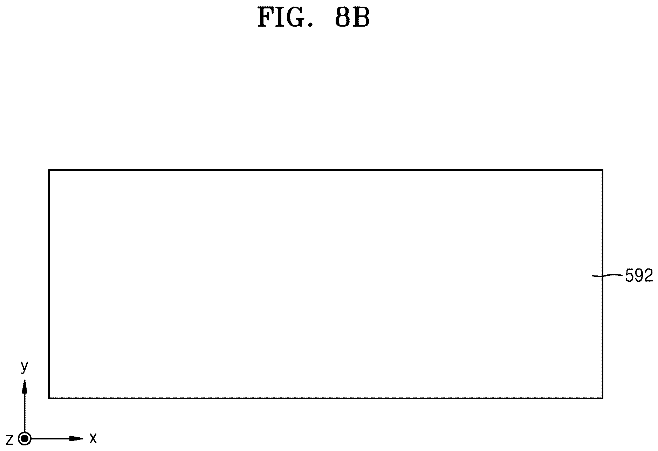

FIGS. 8A, 9A, 10A, 11A, 12A, 13A, 14A, 15A, and 16A are cross-sectional views of a manufactured structure, and FIGS. 8B, 9B, 10B, 11B, 12B, 13B, 14B, 15B, and 16B are plan views of the same. Referring to FIGS. 8A and 8B, a plurality of interlayer insulating layers 591 and a plurality of sacrificial layers 595 are alternately stacked in the direction (z-axis direction) perpendicular to the substrate 501, and then an upper insulating layer 592 is stacked thereon.

The substrate 501 may include various materials. For example, the substrate 501 may include a single crystal silicon substrate, a compound semiconductor substrate, and/or an SOI substrate. However, this is merely an example, and the substrate 501 of various materials may be used. In addition, the substrate 501 may further include, for example, an impurity region caused by doping, an electronic device such as a transistor, and/or a peripheral circuit selecting and controlling memory cells that store data.

The interlayer insulating layer 591 corresponds to the above-described first insulating layer 591 shown in FIG. 5C, and may include, for example, at least one of SiO, SiOC, and/or SiON, but is not limited thereto. The sacrificial layer 595 may include a material having an etching selectivity with respect to the interlayer insulating layer 591. For example, the sacrificial layer 591 may include SiN, but is not limited thereto. The upper insulating layer 592 corresponds to the second insulating layer 592 shown in FIG. 5C, and may be provided to pattern the interlayer insulating layer 591 and the sacrificial layer 595. The upper insulation layer 592 may include a material having an etching selectivity with respect to the interlayer insulation layer 591 and the sacrificial layer 595.

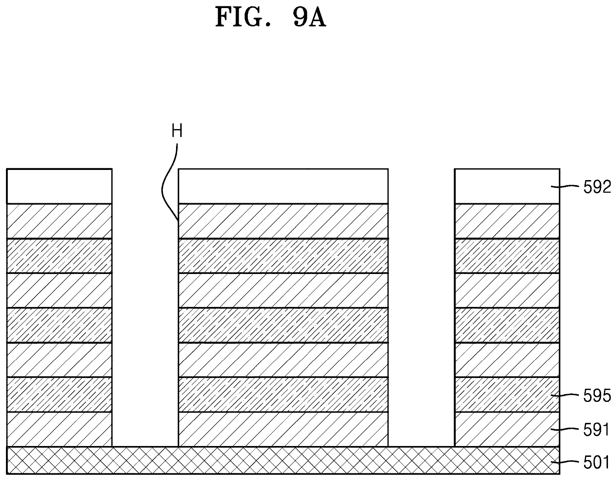

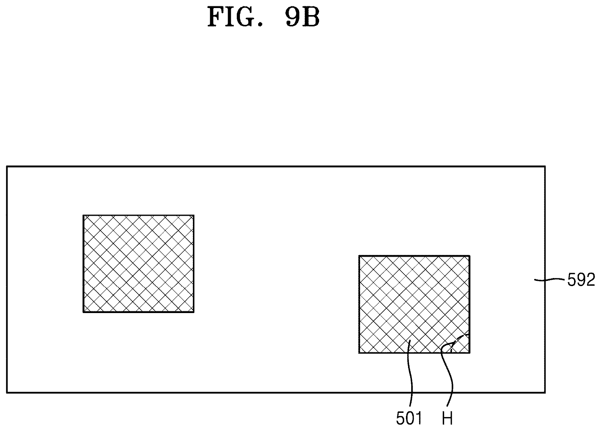

Referring to FIGS. 9A and 9B, after the upper insulating layer 592 is patterned, a plurality of through holes H penetrating the interlayer insulating layers 591 and the sacrificial layers 595 are formed using the patterned upper insulating layer 592 as an etching mask. FIGS. 9A and 9B illustrate two through holes H. The through holes H may be formed to extend in the direction (z-axis direction) perpendicular to the substrate 501. Side surfaces of the interlayer insulating layers 591 and the sacrificial layers 595 may be exposed through the through holes H.

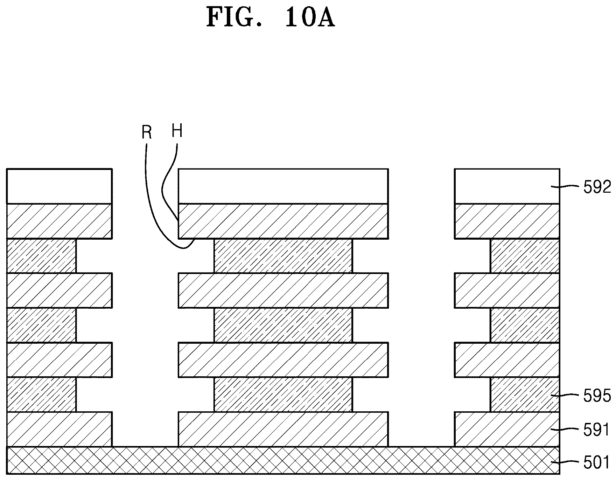

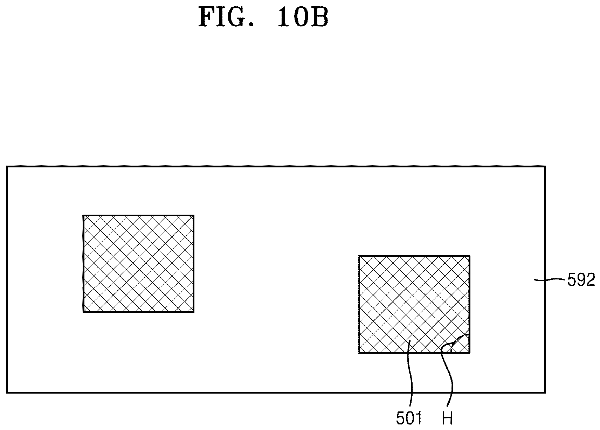

Referring to FIGS. 10A and 10B, recesses R are formed by etching the side surfaces of the sacrificial layers 595 exposed through the through hole H. Here, each recess R may extend to a certain depth parallel to a surface of the substrate 501 from the side surfaces of the sacrificial layer 595.

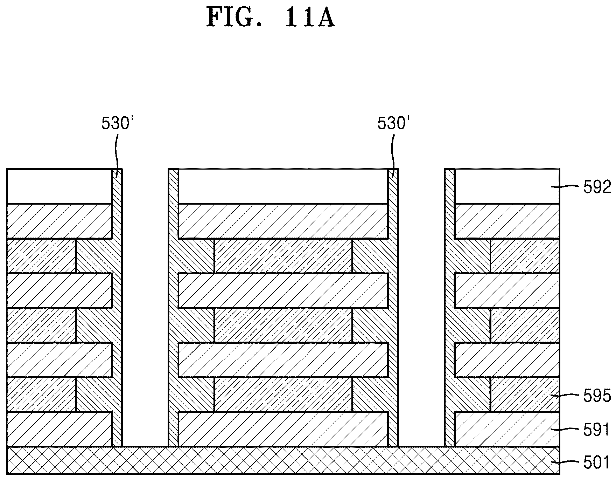

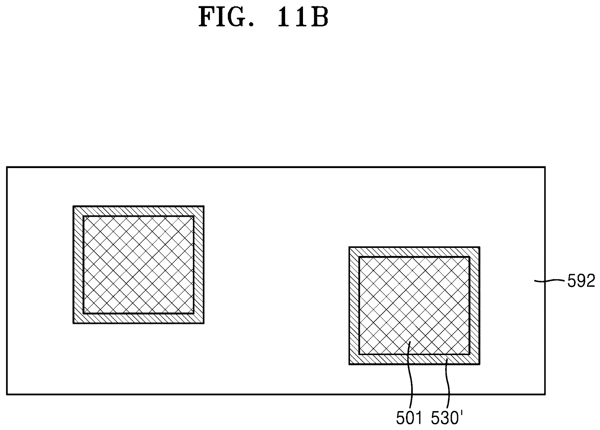

Referring to FIGS. 11A and 11B, an intermediate conductive material layer 530' is formed to cover the side surfaces of the interlayer insulating layers 591 and the recesses R. Here, the intermediate conductive material layer 530' may include a conductive material such as metal, metal nitride, metal oxide, polysilicon, etc. For example, the intermediate conductive material layer 530' may include at least one of W, TiN, TaN, WN, NbN, Mo, Ru, Ir, RuO, IrO, and/or highly doped poly silicon. However, this is merely an example, and the intermediate conductive material layer 530' may include various other conductive materials.

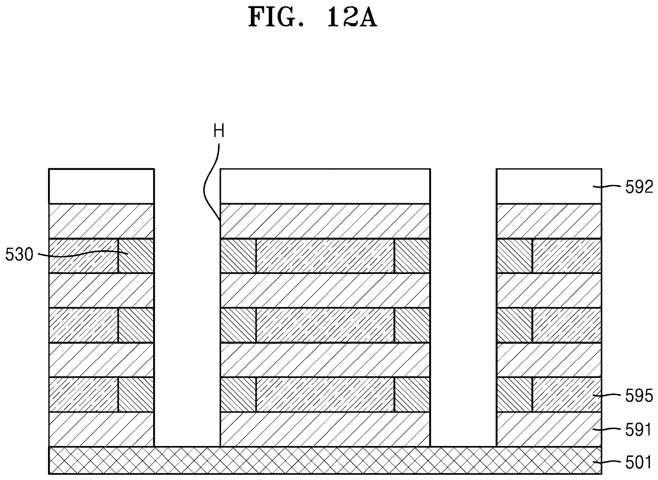

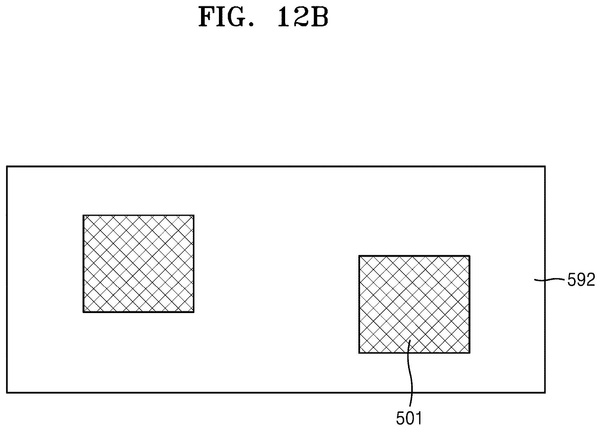

Referring to FIGS. 12A and 12B, the plurality of intermediate conductive layers 530 are formed by etching the intermediate conductive material layer 530' until the side surfaces of the interlayer insulating layer 591 are exposed. Each intermediate conductive layer 530 is in contact with a side surface of the sacrificial layer 595 and may be provided to fill the recess R.

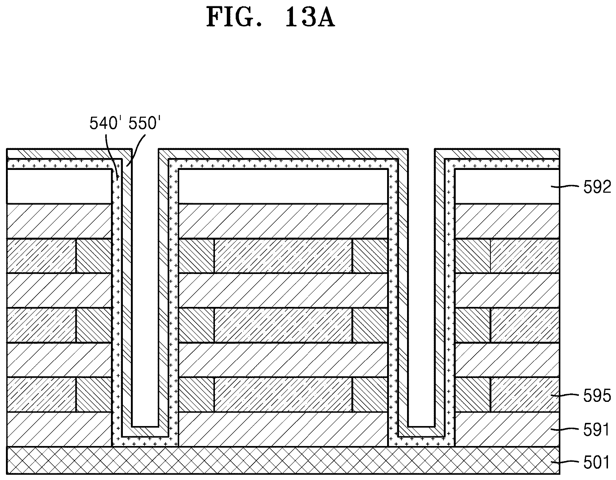

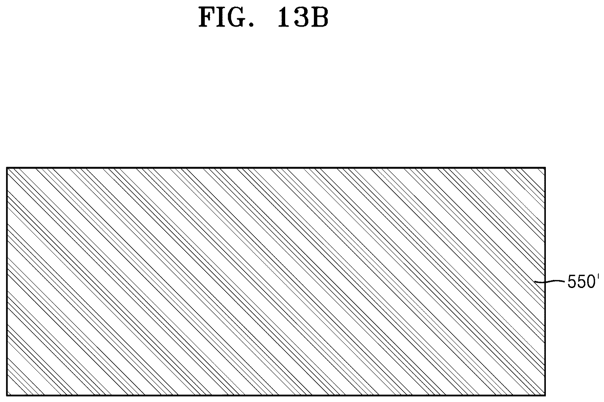

Referring to FIGS. 13A and 13B, a gate insulating material layer 540' and a channel material layer 550' are sequentially formed to cover an upper surface of the upper insulating layer 592 and inner walls of the through holes H. The gate insulating material layer 540' may include at least one of, for example, silicon oxide (SiO), silicon nitride (SiN), hafnium oxide (HfO), and/or zirconium oxide (ZrO). However, this is merely an example. For example, the channel material layer 550' may include a group IV semiconductor such as Si, Ge, SiGe, etc., a group III-V semiconductor compound, an oxide semiconductor, a nitride semiconductor, a nitride semiconductor, a 2D semiconductor material, a quantum dot, and/or an organic semiconductor. The channel material layer 150' may further include a dopant.

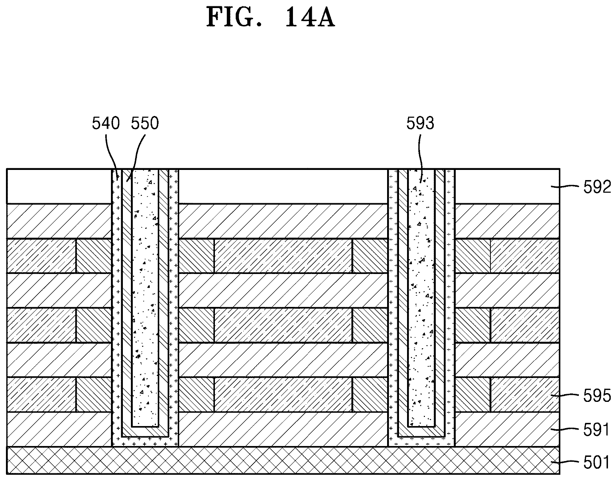

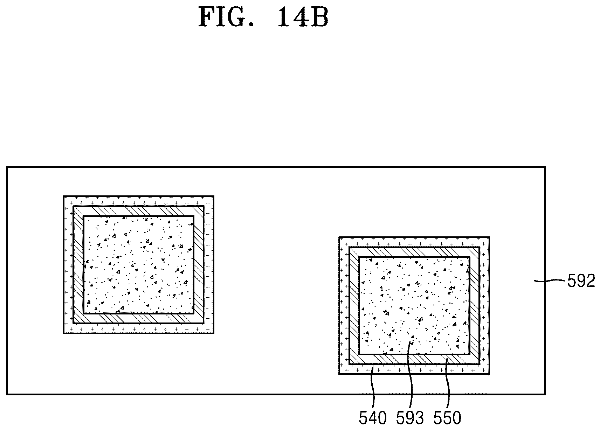

Referring to FIGS. 14A and 14B, a planarization process is performed after the filling insulating layer 593 is formed to fill the through holes H. The filling insulation layer 593 may correspond to the third insulation layer 593 shown in FIG. 5C. Accordingly, the gate insulating layer 540 may be formed on the inner wall of each through hole H to be in contact with the intermediate conductive layers 530, and the channel layer 550 may be formed in the gate insulating layer 540. Here, the gate insulation layer 540 and the channel layer 550 may be formed to extend in the direction (z-axis direction) perpendicular to the substrate 501.

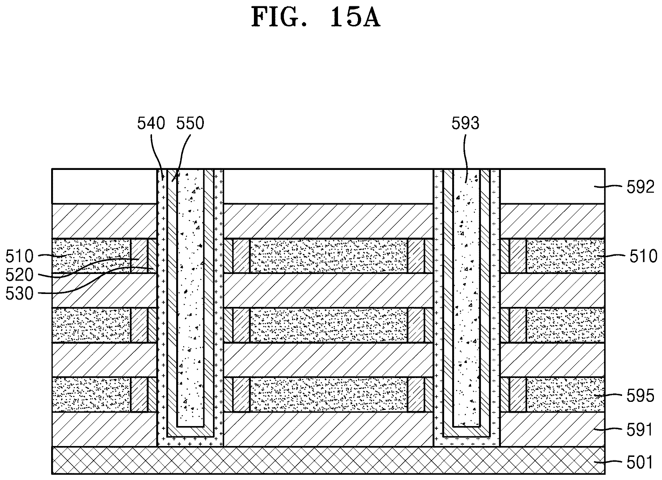

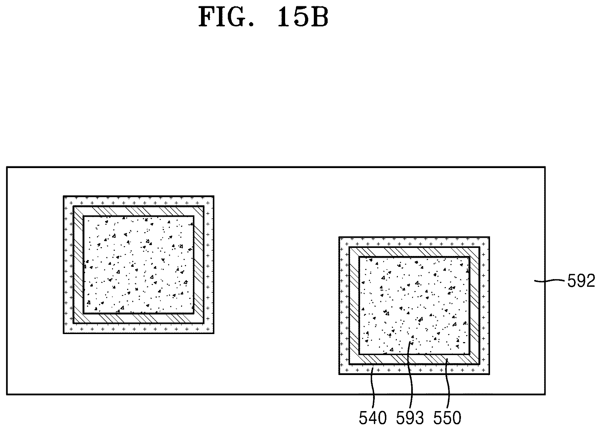

Referring to FIGS. 15A and 15B, after the sacrificial layer 595 between the interlayer insulating layers 591 is removed, the ferroelectric layer 520 and the gate electrode 510 are sequentially formed in the intermediate conductive layer 530 exposed through the removal of the sacrificial layer 595. The ferroelectric layer 520 may include, for example, a fluorite-based ferroelectric material, a nitride-based ferroelectric material, and/or a perovskite-based ferroelectric material. The fluorite-based material may include at least one of, for example, hafnium oxide (HfO), zirconium oxide (ZrO), and/or hafnium-zirconium oxide (HfZrO). The nitride-based material may include, for example, AlScN etc. The perovskite-based material may include PZT, SBT, BTO, etc. The ferroelectric layer 520 may further include a certain dopant. The dopant may include at least one of, for example, La, Y, Gd, Si, Al, Mg, Sr, and/or Ba. However, the disclosure is not limited thereto. The gate electrode 510 may include a conductive material. For example, the gate electrode 510 may include a metal, a metal nitride, a metal oxide, polysilicon, etc. For example, the gate electrode 510 may include at least one of W, TiN, TaN, WN, NbN, Mo, Ru, Ir, RuO, IrO, and/or highly doped poly silicon. However, the disclosure is not limited thereto.

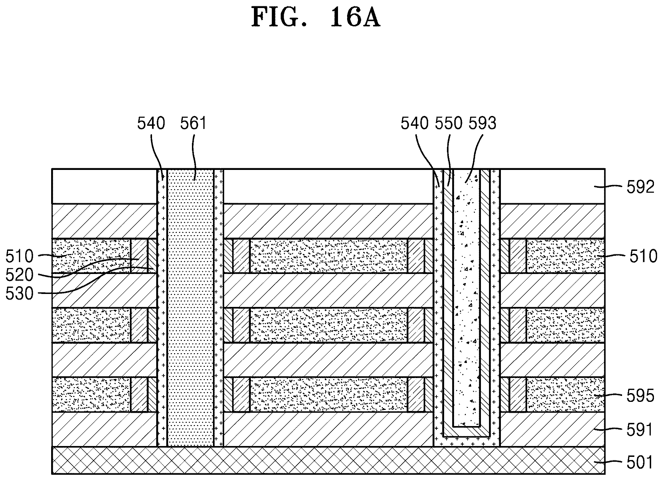

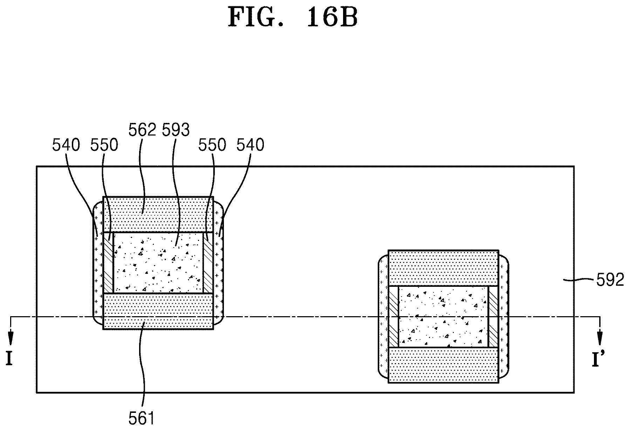

FIG. 16A is a cross-sectional view taken along line I-I' of FIGS. 16B. Referring to FIGS. 16A and 16B, a source through hole (not shown) and a drain through hole (not shown) are formed by etching both sides of the filling insulating layer 593 and the channel layer 550 in the direction (z-axis direction) perpendicular to the substrate 501, respectively. Here, the source through hole and the drain through hole may be formed to be spaced apart from each other in the direction (z-axis direction) perpendicular to the substrate 501. The gate insulating layer 540 may be exposed through the source through hole and the drain through hole. Subsequently, the source electrode 561 is formed to fill the source through hole, and the drain electrode 562 is formed to fill the drain through hole. Accordingly, the source electrode 561 and the drain electrode 562 may be formed to be in direct contact with the gate insulating layer 540 in both sides of the channel layer 550.

The source electrode 561 and the drain electrode 562 may each include a conductive material. The source electrode 561 and the drain electrode 562 may be formed to extend in the direction (z-axis direction) perpendicular to the substrate 501. The source electrode 561 and the drain electrode 562 may be formed to be spaced apart from each other in the first direction (y-axis direction) parallel to the substrate 501. The gate electrode 510, the ferroelectric layer 520, the intermediate conductive layer 530, the gate insulating layer 540, and the channel layer 550 may be sequentially stacked in the second direction (x-axis direction) parallel to the substrate 501. The gate electrode 510, the ferroelectric layer 520, the intermediate conductive layer 530, the gate insulating layer 540, and the channel layer 550 may be provided in both sides of the source electrode 561 and the drain electrode 562, respectively.

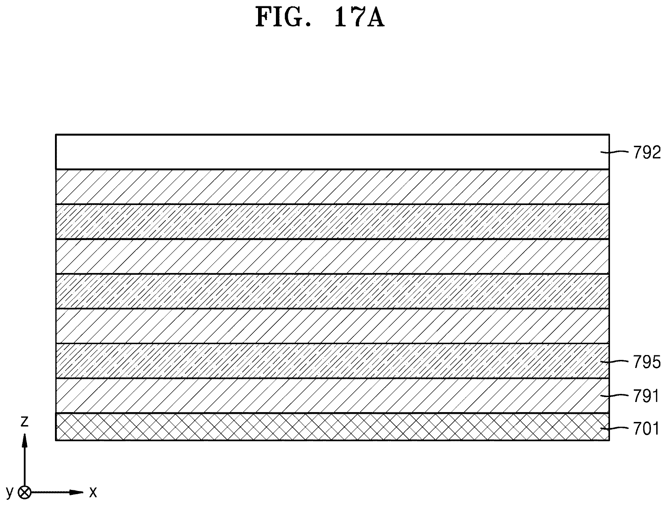

FIGS. 17A to 26B are diagrams for explaining a method of manufacturing the memory device 700 according to at least one example embodiment. The method of manufacturing the memory device 700 shown in FIGS. 7A and 7B is shown in FIGS. 17A to 26B.

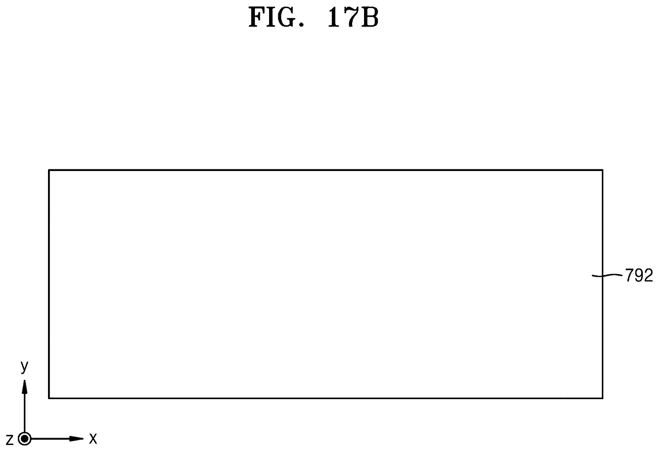

FIGS. 17A, 18A, 19A, 20A, 21A, 22A, 23A, 24A, 25A, and 26A are cross-sectional views of a manufactured structure, and FIG. 17B, 18B, 19B, 20B, 21B, 22B, 23B, 24B, 25B, and 26B are plan views of the same. Referring to FIGS. 17A and 17B, a plurality of interlayer insulating layers 791 and a plurality of sacrificial layers 795 are alternately stacked in the direction (z-axis direction) perpendicular to the substrate 701, and then an upper insulating layer 792 is stacked thereon.

The substrate 701 may include various materials. For example, the substrate 701 may include a single crystal silicon substrate, a compound semiconductor substrate, and/or an SOI substrate. However, this is merely an example, and the substrate 701 of various materials may be used. In addition, the substrate 701 may further include, for example, an impurity region caused by doping, an electronic device such as a transistor, and/or a peripheral circuit selecting and controlling memory cells that store data.

The interlayer insulating layer 791 corresponds to the first insulating layer 591 shown in FIG. 7B, and may include, for example, at least one of SiO, SiOC, and/or SiON, but is not limited thereto. The sacrificial layer 795 may include a material having an etching selectivity with respect to the interlayer insulating layer 791. The upper insulating layer 792 corresponds to the second insulating layer 792 shown in FIG. 7B, and may be provided to pattern the interlayer insulating layer 791 and the sacrificial layer 795. The upper insulating layer 792 may include a material having an etching selectivity with respect to the interlayer insulating layer 791 and the sacrificial layer 795.

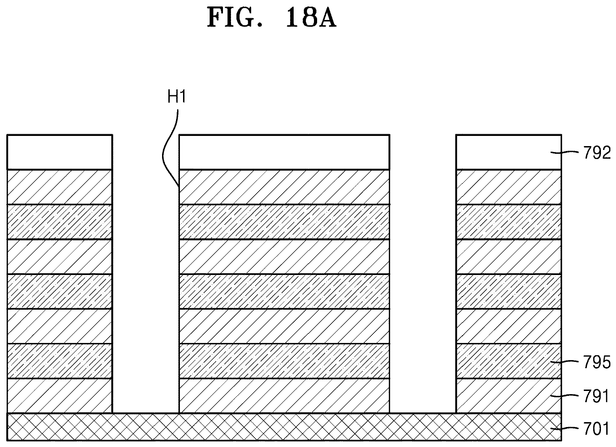

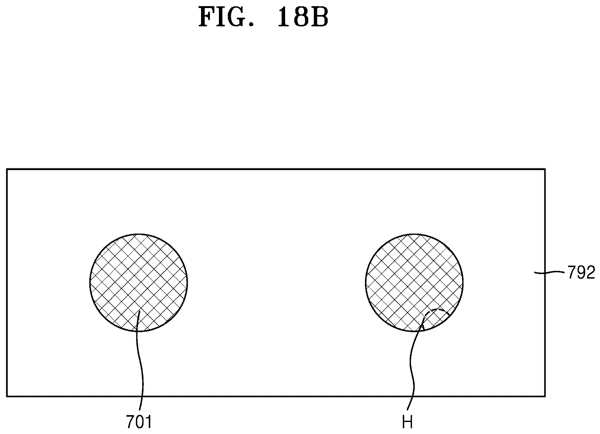

Referring to FIGS. 18A and 18B, after the upper insulation layer 792 is patterned, first through holes H1 penetrating the interlayer insulation layers 791 and the sacrificial layers 795 are formed using the patterned upper insulation layer 792 as an etching mask. The first through hole H1 may be formed to have, for example, a circular cross section. FIGS. 18A and 18B illustrate two first through holes H1. The first through hole H1 may be formed to extend in the direction (z-axis direction) perpendicular to the substrate 701. Side surfaces of the interlayer insulating layers 791 and the sacrificial layers 795 may be exposed through the first through hole H1.

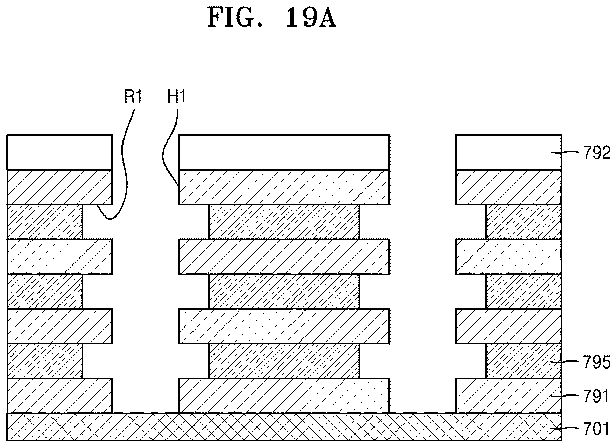

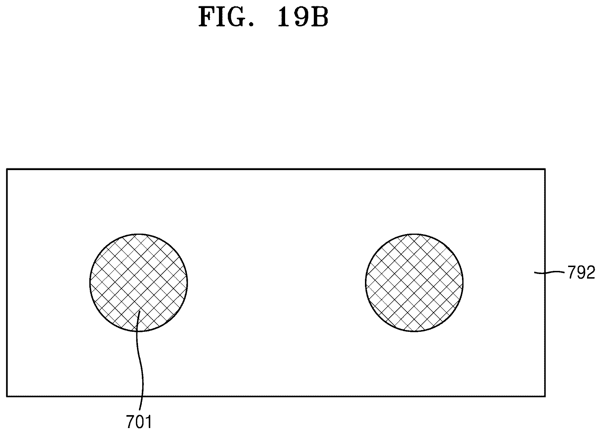

Referring to FIGS. 19A and 19B, first recesses R1 are formed by etching the side surfaces of the sacrificial layers 795 exposed through the first through hole H1. Here, each first recess R1 may extend to a certain depth parallel to a surface of the substrate 701 from the side surfaces of the sacrificial layer 795.

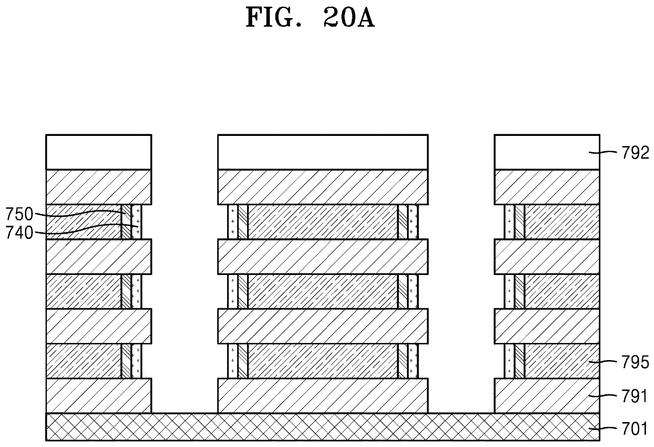

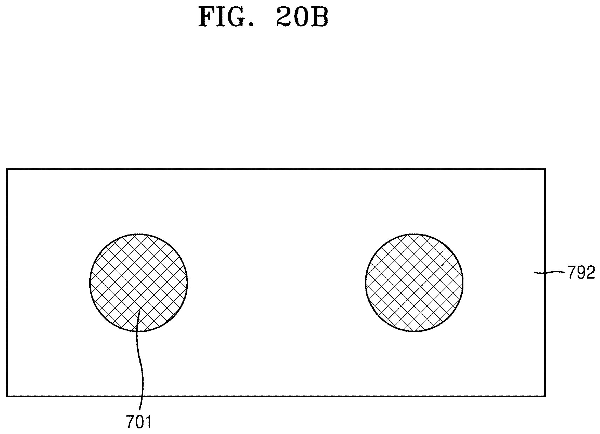

Referring to FIGS. 20A and 20B, the channel layer 750 and the gate insulating layer 740 are sequentially formed on the sacrificial layer 795 exposed through the first recess R1. The channel layer 750 may include, for example, a group IV semiconductor such as Si, Ge, and SiGe, a group III-V semiconductor compound, an oxide semiconductor, a nitride semiconductor, a nitride semiconductor, a 2D semiconductor material, a quantum dot, and/or an organic semiconductor. The channel layer 750 may further include a dopant. For example, the gate insulating layer 740 may include at least one of silicon oxide (SiO), silicon nitride (SiN), hafnium oxide (HfO), and/or zirconium oxide (ZrO). However, this is merely an example.

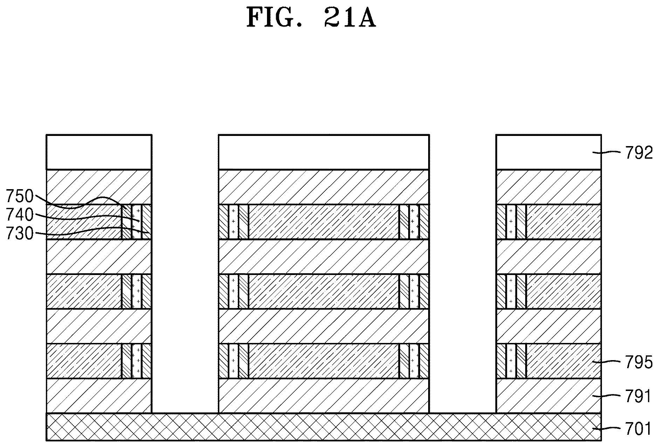

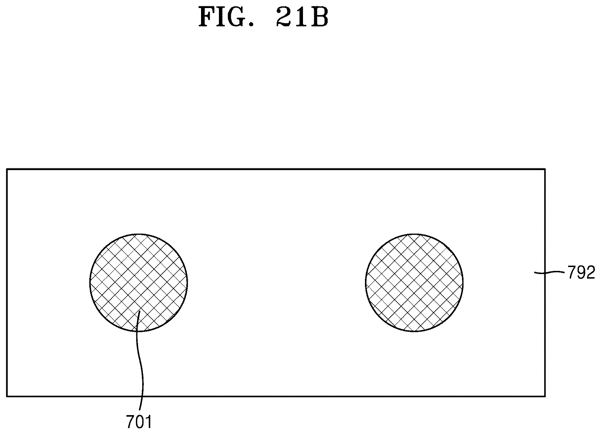

Referring to FIGS. 21A and 21B, the intermediate conductive layer 730 is formed on the channel layer 740. The intermediate conductive layer 730 may be formed to fill the first recess R1. The intermediate conductive layer 730 may include a conductive material such as metal, metal nitride, metal oxide, polysilicon, etc. For example, the intermediate conductive layer 730 may include at least one of W, TiN, TaN, WN, NbN, Mo, Ru, Ir, RuO, IrO, and/or highly doped poly silicon. However, this is merely an example, and the intermediate conductive layer 730 may include various other conductive materials.

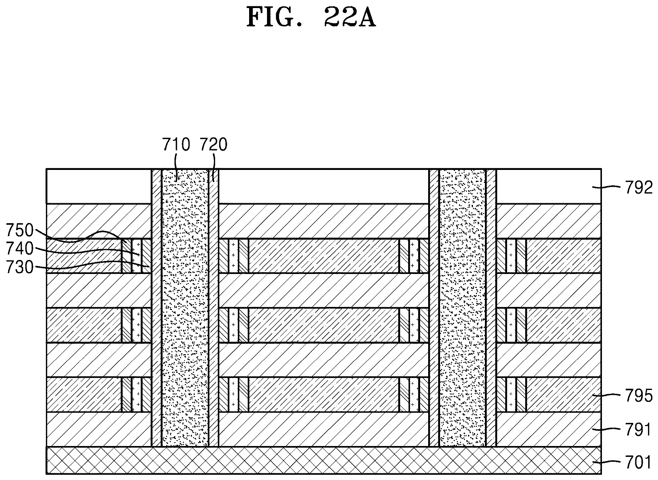

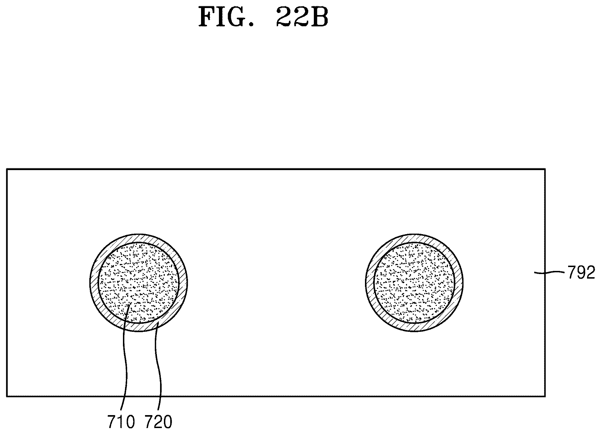

Referring to FIGS. 22A and 22B, the ferroelectric layer 720 is formed on an inner wall of each first through hole H1 to be in contact with the intermediate conductive layers 730, and then the gate electrode 710 is formed on the ferroelectric layer 720. Each of the ferroelectric layer 720 and the gate electrode 710 may be formed to extend in the direction (z-axis direction) perpendicular to the substrate 701. The gate electrode 710 may be formed to fill, for example, the first through hole H1.

The ferroelectric layer 720 may include, for example, a fluorite-based ferroelectric material, a nitride-based ferroelectric material, and/or a perovskite-based ferroelectric material. The fluorite-based material may include at least one of, for example, hafnium oxide (HfO), zirconium oxide (ZrO), and/or hafnium-zirconium oxide (HfZrO). The nitride-based material may include, for example, AlScN, etc. The perovskite-based material may include PZT, SBT, and/or BTO. The ferroelectric layer 720 may further include a certain dopant. The dopant may include at least one of, for example, La, Y, Gd, Si, Al, Mg, Sr, and/or Ba. However, the disclosure is not limited thereto. The gate electrode 710 may include a conductive material. For example, the gate electrode 710 may include a metal, a metal nitride, a metal oxide, polysilicon, etc. For example, the gate electrode 710 may include at least one of W, TiN, TaN, WN, NbN, Mo, Ru, Ir, RuO, IrO, and/or highly doped poly silicon. However, the disclosure is not limited thereto.

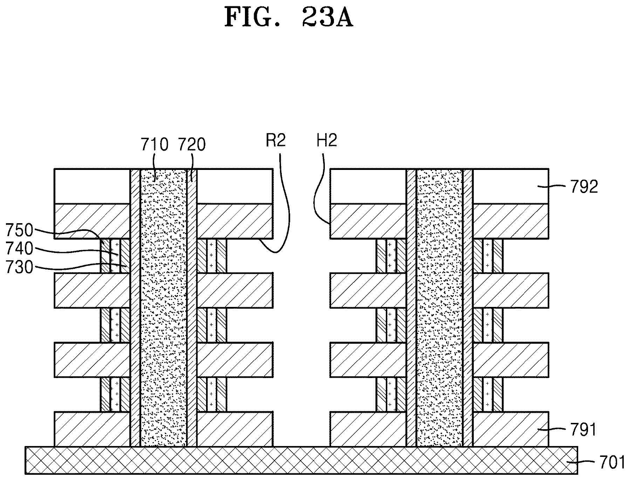

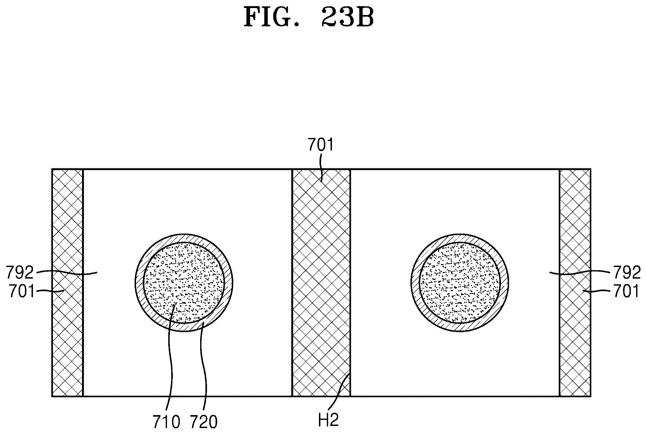

Referring to FIGS. 23A and 23B, an upper insulating layer 792 is patterned, and then a second through hole H2 penetrating the interlayer insulating layers 791 and the sacrificial layers 795 is formed using the patterned upper insulating layer 792 as an etching mask. The second through hole H2 may serve to separate the adjacent cell arrays CA of FIG. 7A from each other. Subsequently, a second recess R2 exposing the channel layer 750 is formed by removing the sacrificial layer 795 exposed through the second through hole H2.

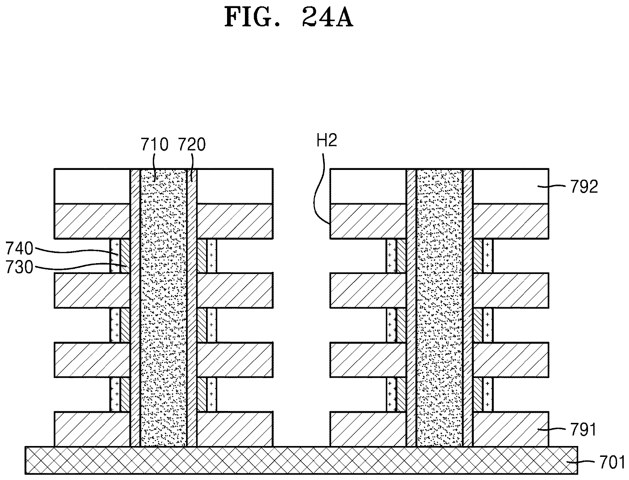

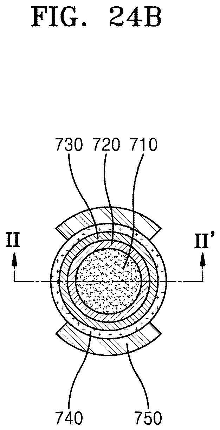

Referring to FIGS. 24A and 24B, both sides of the gate insulating layer 740 are exposed by etching and removing a part of the channel layer 750. FIG. 24B is a plan view illustrating both sides of the gate insulating layer 740 exposed by etching the channel layer 750, and FIG. 24A is a cross-section view taken along the line II-II' of FIG. 24B.

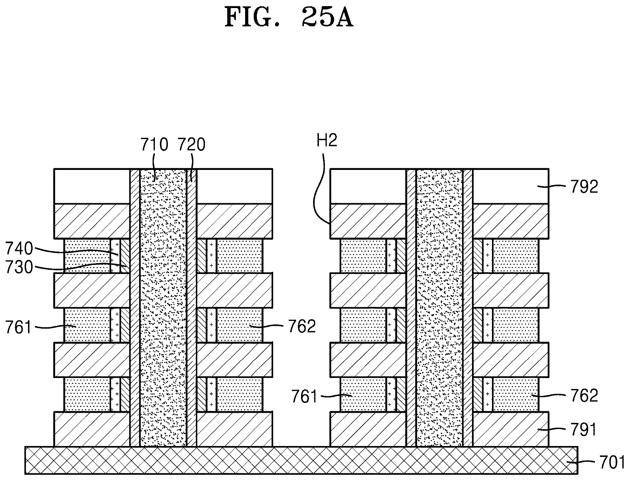

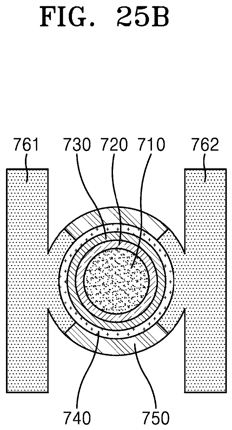

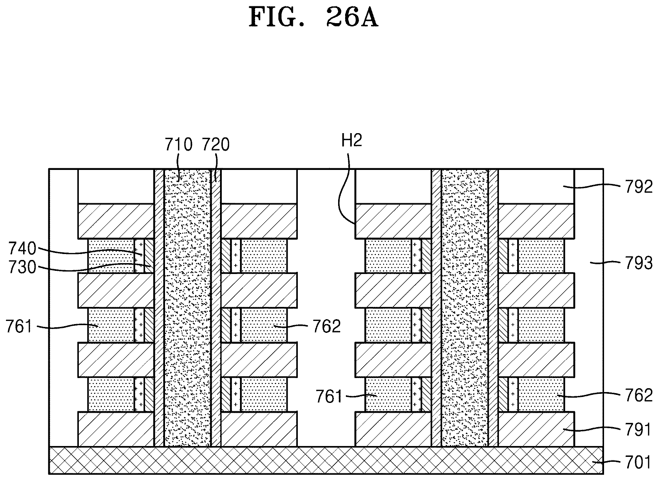

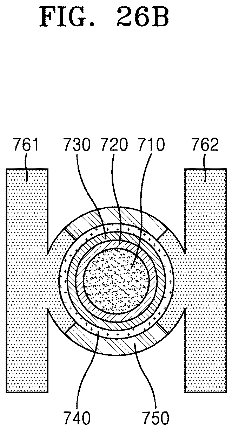

Referring to FIGS. 25A and 25B, the source electrode 761 and the drain electrode 762 are formed in both sides of the channel layer 750, respectively. The source electrode 761 and the drain electrode 762 may each include a conductive material. The source electrode 761 may be formed to be in direct contact with one side of the gate insulating layer 740, and the drain electrode 762 may be formed to be in direct contact with the other side of the gate insulating layer 740. FIG. 25B is a plan view illustrating the source electrode 761 and the drain electrode 762 formed to contact both sides of the gate insulation layer 740, and FIG. 25A is a cross-section view of FIG. 25B. Referring to FIGS. 26A and 26B, a filling insulation layer 793 is formed to fill the second through hole H2 and the second recess R2.

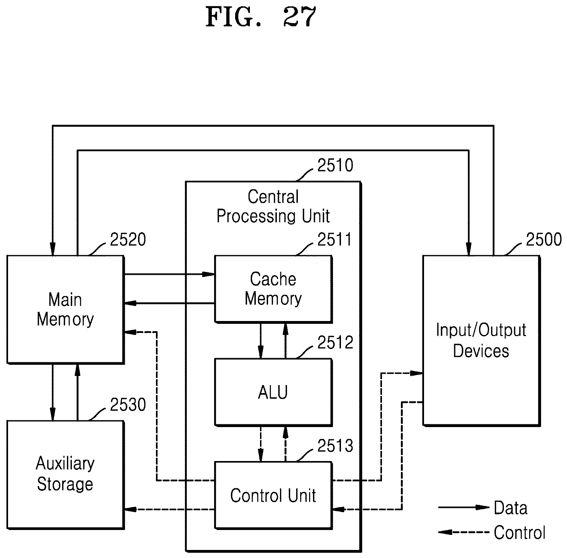

The semiconductor devices 100, 200, and 300 and the memory devices 500, 600, and 700 according to the embodiment described above may be applied to various electronic devices. FIG. 27 is a conceptual view schematically illustrating device architecture applicable to an electronic apparatus.

Referring to FIG. 27, a cache memory 2511, an arithmetic logic unit (ALU) 2512, and a control unit 2513 may constitute a central processing unit (CPU) 2510, and the cache memory 2511 may include a static random access memory (SRAM). Aside from the CPU 2510, a main memory 2520 and an auxiliary storage 2530 may be provided. In addition, an input/output device 2500 may be further provided. The main memory 2520 and the auxiliary storage 2530 may each include the semiconductor devices 100, 200, and/or 300 and/or the memory devices 500, 600, and/or 700 described above. In some cases, the device architecture may be implemented in the form in which computing unit components and memory unit component are adjacent to each other in one chip without distinction of sub-units.

The memory devices 500, 600, and 700 described above are implemented as a memory block in the form of a chip and may be used as a neuromorphic computing platform or for establishing a neural network.

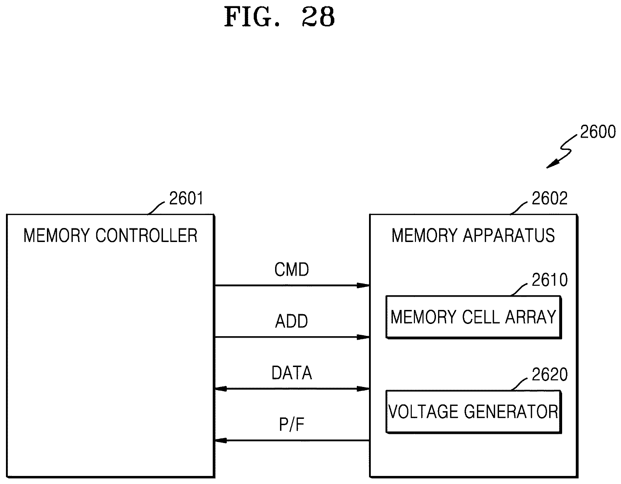

FIG. 28 is a block diagram of a memory system 2600 according to at least one example embodiment.

Referring to FIG. 28, the memory system 2600 may include a memory controller 2601 and a memory apparatus 2602. The memory controller 2601 performs a control operation on the memory apparatus 2602. For example, the memory controller 2601 provides the memory apparatus 2602 with an address ADD and a command CMD to perform program (or write), read, and/or erase operations with respect to the memory apparatus 2602. In addition, data for the program operation and the reading data may be transmitted between the memory controller 2601 and the memory apparatus 2602.

The memory apparatus 2602 may include a memory cell array 2610 and a voltage generator 2620. The memory cell array 2610 may include a plurality of memory cells, the semiconductor devices 100, 200, and/or 300, and/or the memory devices 500, 600, and/or 700 described above.

The memory controller 2601 may include processing circuitry such as hardware including a logic circuit, a hardware/software combination such as processor execution software, and/or a combination thereof. For example, as noted above, the processing circuitry may include a CPU, an ALU, a digital signal processor, a microcomputer, a field programmable gate array (FPGA), a system-on-chip (SoC), a programmable logic unit, a microprocessor, an application-specific integrated circuit (ASIC), etc., but the disclosure is not limited thereto. The memory controller 2601 may be configured to operate, in response to a request from a host (not shown), access the memory apparatus 2602, and control the control operation (e.g., write/read operation) disclosed above, thereby converting the memory controller 2601 into a special purpose controller. The memory controller 2601 may generate an address ADD and a command CMD to perform program/read/erase operations on the memory cell array 2610. In addition, in response to the command CMD from the memory controller 2601, the voltage generator 2620 (e.g., a power circuit) may generate a voltage control signal to control a voltage level of a word line for data programming or data reading in the memory cell array 2610.

In addition, the memory controller 2601 may perform an operation of determining data read out from the memory apparatus 2602. For example, the number of on-cells and/or off-cells may be determined from the data read out from the memory cell. The memory apparatus 2602 may provide a pass/fail signal P/F to the memory controller 2601 according to a reading data reading result. The memory controller 2601 may control write and read operations of the memory cell array 2610 with reference to the pass/fail signal P/F.

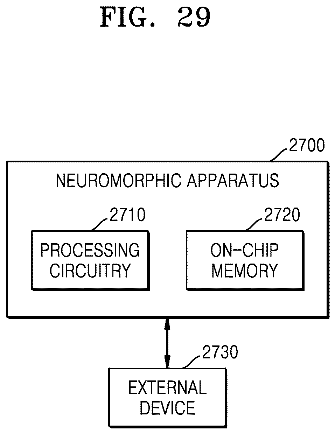

FIG. 29 is a block diagram of a neuromorphic apparatus 2700 according to at least one example embodiment and an external device 2730 connected thereto.

Referring to FIG. 29, the neuromorphic apparatus 2700 may include a processing circuitry 2710 and/or an on-chip memory 2720. The neuromorphic apparatus 2700 may include the semiconductor devices 100, 200, and/or 300 and/or the memory devices 500, 600, and 700 described above.

In some embodiments, the processing circuitry 2710 may be configured to control a function to drive the neuromorphic apparatus 2700. For example, the processing circuitry 2710 may be configured to control the neuromorphic apparatus 2700 by executing a program stored in the on-chip memory 2720. For example, the processing circuitry 2710 may include a CPU, a graphics processing device (GPU), an application processor (AP) included in the neuromorphic apparatus 2700, an ALU, a digital signal processor, a microcomputer, an FPGA, an SoC, a programmable logic unit, a microprocessor, an ASIC, etc., but the disclosure is not limited thereto. In some embodiments, the processing circuitry 2710 may be configured to execute read/write various pieces of data with respect to the external device 2730, and/or operate the neuromorphic apparatus 2700 using the read/written data. In some embodiments, the external device 2730 may include an external memory and/or sensor array including an image sensor (e.g., a CMOS image sensor circuit).

In some embodiments, the neuromorphic apparatus 2700 of FIG. 29 may be applied to machine learning systems. Such machine learning systems may utilize various artificial neural network organizational and processing models, such as convolutional neural networks (CNN), de-convolutional neural networks, recurrent neural networks (RNN) optionally including long short-term memory (LSTM) units and/or gated recurrent units (GRU), stacked neural networks (SNN), state-space dynamic neural networks (SSDNN), deep belief networks (DBN), generative adversarial networks (GANs), and/or restricted Boltzmann machines (RBM).

Alternatively, or additionally, such machine learning systems may include other forms of machine learning models, such as, for example, linear and/or logistic regression, statistical clustering, Bayesian classification, decision trees, dimensionality reduction such as principal component analysis, and expert systems; and/or combinations thereof, including ensembles such as random forests. Such machine learning models may be used to provide various services and/or applications, for example, an image classify service, a user authentication service based on bio-information or biometric data, an advanced driver assistance system (ADAS) service, a voice assistant service, an automatic speech recognition (ASR) service, etc., and may be executed by other electronic devices.

It should be understood that the example embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A ferroelectric field effect transistor (FeFET) comprising:
a gate electrode;
a ferroelectric layer on the gate electrode;
an intermediate conductive layer on the ferroelectric layer such that the ferroelectric layer is between the intermediate conductive layer and the gate electrode;
a gate insulating layer on the intermediate conductive layer such that the intermediate conductive layer is between the gate insulating layer and the ferroelectric layer;
a channel layer on the gate insulating layer such that the gate insulating layer is between the channel layer and the intermediate conductive layer; and
a source electrode and a drain electrode on the channel layer, both the source electrode and the drain electrode directly contacting the gate insulating layer.

2. The FeFET of claim 1, wherein
the channel layer define a first through hole and a second through hole in the channel layer,
the source electrode is in contact with the gate insulating layer through the first through hole, and
the drain electrode is in contact with the gate insulating layer through the second through hole.

3. The FeFET of claim 1 or 2, wherein the channel layer includes at least one of a group IV semiconductor, a group III-V semiconductor compound, an oxide semiconductor, a nitride semiconductor, a nitride oxide semiconductor, a two-dimensional (2D) semiconductor, a quantum dot, or an organic semiconductor.

4. The FeFET of any preceding claim, wherein the channel layer includes a doping region in contact with at least one of the source electrode or the drain electrode.

5. The FeFET of any preceding claim, further comprising:
an interface layer is between the channel layer and at least one of the source electrode or the drain electrode.

6. The FeFET of any preceding claim, wherein each of the gate electrode and the intermediate conductive layer independently includes at least one of a metal, a metal nitride, a metal oxide, or a highly doped poly silicon.

7. The FeFET of any preceding claim, wherein the ferroelectric layer includes at least one of a fluorite-based ferroelectric material, a nitride-based ferroelectric material, or a perovskite-based ferroelectric material.

8. The FeFET of any preceding claim, wherein the gate insulating layer includes at least one of silicon oxide, silicon nitride, hafnium oxide, or zirconium oxide.

9. A memory device comprising:
a plurality of memory cells according to any preceding claim perpendicular to a substrate, each of the plurality of memory cells.

10. The memory device of claim 9, wherein each of the source electrode and the drain electrode is configured to extend in a direction perpendicular to the substrate and be shared by the plurality of memory cells.

11. The memory device of claim 10, wherein the source electrode and the drain electrode are spaced apart from each other in a first direction parallel to the substrate and optionally, wherein the gate electrode, the ferroelectric layer, the intermediate conductive layer, the gate insulating layer, and the channel layer are stacked in a second direction parallel to the substrate.

12. The memory device of claim 11, wherein the gate electrode, the ferroelectric layer, the intermediate conductive layer, the gate insulating layer, and the channel layer are on at least one side of each of the source electrode and the drain electrode.

13. The memory device of claim 9, wherein the gate electrode is configured to extend in a direction perpendicular to the substrate and to be shared by the plurality of memory cells.

14. The memory device of claim 10 or 13, wherein the source electrode and the drain electrode are spaced apart from each other in a direction parallel to the substrate.

15. The memory device of claim 14, wherein the ferroelectric layer, the intermediate conductive layer, and the gate insulating layer are surround the gate electrode.
